# EUROPÄISCHE PATENTSCHRIFT

(11) **EP 3 234 457 B1**
(45) Veröffentlichungstag und Bekanntmachung des Hinweises auf die Patenterteilung: **28.11.2018**
(21) Anmeldenummer: 15813006.2
(22) Anmeldetag: 11.12.2015
(51) Int. Cl.: F21V 19/00, F21V 21/02, H05K 3/00, F21Y 115/10

(54) **LEUCHTMITTELTRÄGER FÜR EINE LICHTBANDLEUCHTE**
LIGHTING-MEANS CARRIER FOR A STRIP-LIGHTING LUMINAIRE
SUPPORT À SOURCE LUMINEUSE POUR UN LUMINAIRE TYPE CHEMIN LUMINEUX

(30) Priorität: 17.12.2014 DE 202014106099 U
(43) Veröffentlichungstag der Anmeldung: 25.10.2017
(73) Patentinhaber: Zumtobel Lighting GmbH, 6850 Dornbirn (AT)
(72) Erfinder: BADER, Martin, 6850 Dornbirn (AT); BECHTER, Wolfgang, 6952 Hittisau (AT); GADNER, Wolfgang, 6912 Hörbranz (AT)
(74) Vertreter: Kiwit, Benedikt
(86) Internationale Anmeldenummer: PCT/EP2015/079404
(87) Internationale Veröffentlichungsnummer: WO 2016/096650

(56) Entgegenhaltungen:
- EP-A2- 0 039 445
- EP-A2- 1 247 690
- WO-A1-2006/122392
- US-A1- 2010 080 019
- US-A1- 2010 128 485
- US-A1- 2010 226 136

## Beschreibung

### 1. Gebiet der Erfindung

Die vorliegende Erfindung betrifft einen Leuchtmittelträger für eine Lichtbandleuchte, sowie eine Lichtbandleuchte mit einem solchen Leuchtmittelträger.

### 2. Hintergrund

Aus dem Stand der Technik ist eine Vielzahl von unterschiedlichen Lichtbandleuchten bekannt. Mit Lichtbandleuchten bzw. Lichtbandsystemen können vor allem große Räume (beispielsweise Supermärkte, Fabrikhallen, Büroräume, etc.) mit an diese Räume angepassten langen Lichtlinien ausgerüstet werden. Üblicherweise weisen diese Lichtbandleuchten u-förmige Lichtbandschienen auf, in denen die Verkabelung, die (Steuer-)Elektronik und die Beleuchtungsmittel angeordnet werden. US 2010/0.080.019 offenbart eine Lichtbandleuchte gemäß dem Oberbegriff des Anspruchs 1. Zur Vereinfachung der Montage ist es ferner bekannt, die Lichtbandleuchten soweit möglich mit modularen Einheiten aufzubauen. Beispielsweise wird in der Druckschrift DE 20 2012 101 765 U1 offenbart, in einer u-förmigen Lichtbandschiene ein erstes Modul in Form eines Geräteträgers und eine zweites Modul in Form eines Leuchtmittelträgers anzuordnen. Der Leuchtmittelträger weist dabei insbesondere eine Leuchtmittelplatine mit darauf angeordneten bzw. mit darauf anordenbaren Leuchtdioden auf, wobei an der Leuchtmittelplatine üblicherweise ein Kühlkörper angeordnet ist und mit der Leuchtmittelplatine thermisch verbunden ist. Die thermische Verbindung zwischen der Leuchtmittelplatine und dem Kühlkörper wird üblicherweise derart bereitgestellt, dass die Leuchtmittelplatine auf den Kühlkörper mittels eines thermisch gut leitenden Klebstoffs aufgeklebt wird. Alternativ zur Verwendung eines Klebstoffes ist es ebenfalls bekannt, die Leuchtmittelplatine mit dem Kühlkörper an verschiedenen Stellen zu verschrauben, so dass eine zuverlässige Kontaktierung der Leuchtmittelplatine mit dem Kühlkörper gewährleistet werden kann. In der Praxis hat sich nunmehr gezeigt, dass die Leuchtmittelplatine und der Kühlkörper ein unterschiedliches Wärmeausdehnungsverhalten aufweisen (insbesondere auch aufgrund der Verwendung unterschiedlicher Materialien mit unterschiedlichen Wärmeausdehnungskoeffizienten). Daher kann es in der Praxis vorkommen, dass an der Verbindung der Leuchtmittelplatine mit dem Kühlkörper hohe Spannungen auftreten, die zur Rissbildung in der Leuchtmittelplatine oder sogar zum Bruch der Leuchtmittelplatine führen kann.

Ausgehend von diesem Stand der Technik stellt sich die vorliegende Erfindung die Aufgabe, einen Leuchtmittelträger mit einer Leuchtmittelplatine und einen mit der Leuchtmittelplatine thermisch verbundenen Kühlkörper bereitzustellen, bei dem die Gefahr der Rissbildung aufgrund unterschiedlicher thermischer Ausdehnungen der Leuchtmittelplatine und des Kühlkörpers verhindert bzw. erheblich reduziert wird.

Diese und andere Aufgaben, die in der folgenden Beschreibung noch genannt werden oder vom Fachmann erkannt werden können, werden mit dem Gegenstand der unabhängigen Ansprüche gelöst.

### 3. Ausführliche Beschreibung der Erfindung

Ein erfindungsgemäßer Leuchtmittelträger für eine Lichtbandleuchte umfasst:
- zumindest eine Leuchtmittelplatine mit darauf anordenbaren Leuchtdioden;
- zumindest einen mit der Leuchtmittelplatine thermisch verbundenen Kühlkörper;
- wobei die Leuchtmittelplatine an einem zentralen Bereich starr mit der Kühlkörper verbunden ist, derart dass im zentralen Bereich im Wesentlichen keine Relativbewegung zwischen der Leuchtmittelplatine und dem Kühlkörper möglich ist;
- wobei die Leuchtmittelplatine an zumindest zwei weiteren Bereichen schwimmend mit dem Kühlkörper verbunden ist, so dass die Leuchtmittelplatine außerhalb des zentralen Bereichs relativ zum Kühlkörper beweglich am Kühlkörper angeordnet ist.

Mit anderen Worten schlägt die vorliegende Erfindung vor, die Leuchtmittelplatine nur an einem Bereich, nämlich am zentralen Bereich starr mit dem Kühlkörper zu verbinden. Unter einem zentralen Bereich im Sinne der vorliegenden Erfindung ist dabei ein mittiger Bereich der Leuchtmittelplatine zu verstehen. Beispielsweise bei einer bevorzugt eingesetzten rechteckigen Leuchtmittelplatine ist dies der Bereich, an dem sich die Symmetrielinien der Leuchtmittelplatine schneiden. Durch die vorgeschlagene Verbindung der Leuchtmittelplatine mit dem Kühlkörper besteht somit die Möglichkeit, dass sich die Leuchtmittelplatine und der Kühlkörper unterschiedlich ausdehnen können, ohne dass dabei Spannungen an den Verbindungsbereichen auftreten können. Gleichzeitig ist dabei eine sichere thermische Verbindung der Leuchtmittelplatine mit dem Kühlkörper gewährleistet.

Vorzugsweise wird die Leuchtmittelplatine im zentralen Bereich durch eine Niet-, Schraub- und/oder Clipverbindung starr mit dem Kühlkörper verbunden. Beispielsweise kann die Leuchtmittelplatine im zentralen Bereich an einer oder mehreren benachbarten Gewindeaufnahme(n) des Kühlkörpers mit diesem verschraubt werden.

Vorteilhafterweise sind die zumindest zwei weiteren Bereiche, an denen die Leuchtmittelplatine schwimmend mit dem Kühlkörper verbunden ist, an zwei gegenüberliegenden Stirnbereichen der Leuchtmittelplatine vorgesehen.

Ferner ist es bevorzugt, dass zumindest eine der schwimmenden Verbindungen der Leuchtmittelplatine mit dem Kühlkörper durch zumindest eine Rastverbindung mittels eines Rastelements bereitgestellt wird, das an einem Abschlussverbinder einer Lichtbandleuchte vorgesehen ist.

Vorteilhafterweise umfasst der Abschlussverbinder zumindest ein weiteres Rastelement, um den Abschlussverbinder mit einer korrespondierend ausgebildeten Aufnahme des Leuchtmittelträgers zu verrasten. Die Verwendung eines solchen Abschlussverbinders ist besonders bevorzugt, da dadurch eine besonders stabile Ausführung des Leuchtmittelträgers bereitgestellt werden kann.

Vorteilhafterweise umfasst der Abschlussverbinder weiterhin ein Positionier- und/oder Abstandselement, das im stirnseitigen Bereich zwischen dem Leuchtmittelträger und einer Lichtbandschiene einer Lichtbandleuchte anordenbar ist. Wie oben bereits ausgeführt, werden in einer modular aufgebauten Lichtbandleuchte, die verschiedenen Module in eine im Wesentlichen u-förmigen Lichtbandschiene angeordnet, dabei kann durch das Positionier- und/oder Abstandselement eine genauere Positionierung des Leuchtmittelträgers in der u-förmigen Lichtbandschiene bereitgestellt werden, so dass auch eine Verbindung des Leuchtmittelträgers mit dem Geräteträger einfacher erfolgen kann.

Vorzugsweise wird zumindest eine der schwimmenden Verbindungen der Leuchtmittelplatine mit dem Kühlkörper durch zumindest eine Rastverbindung mittels eines Rastelements bereitgestellt, das an einer Steckverbinderanordnung vorgesehen ist, die eingerichtet ist, um den Leuchtmittelträger mit einem Geräteträger einer Lichtbandleuchte elektrisch zu verbinden. Mit anderen Worten wird in dieser bevorzugten Ausführungsform zumindest eine der schwimmenden Verbindungen durch eine Steckverbinderanordnung bereitgestellt, die den Leuchtmittelträger mit dem Geräteträger elektrisch verbindet. Demgemäß wird in dieser Ausführungsform kein separates Bauteil (beispielsweise in Form eines Abschlussverbinders) benötigt.

Vorzugsweise ist zumindest ein Rastelement des Abschlussverbinders und/oder der Steckverbinderanordnung durch zumindest eine korrespondierend ausgebildete Aussparung des Leuchtmittelträgers mit der Leuchtmittelplatine in Eingriff bringbar, und zwar derart, dass das Rastelement den Kühlkörper seitlich umgreift und die Leuchtmittelplatine in Kontakt mit dem Kühlkörper hält. Durch eine derartige Verbindung besteht somit die Möglichkeit, dass sich die Leuchtmittelplatine und/oder der Kühlkörper unterschiedlich ausdehnen können, in Längsrichtung der Leuchtmittelplatine durch eine Relativbewegung bezüglich des Rastelements und in Querrichtung durch ein Auseinanderdrücken des Rastelements.

Vorteilhafterweise ist zumindest ein Rastelement des Abschlussverbinders und/oder der Steckverbinderanordnung durch zumindest eine korrespondierend ausgebildete Aussparung des Leuchtmittelträgers mit der Leuchtmittelplatine in Eingriff bringbar, derart dass das Rastelement durch den Kühlkörper und die Leuchtmittelplatine hindurch ragt und die Leuchtmittelplatine in Kontakt mit dem Kühlkörper hält. In dieser Ausgestaltung umfasst das Rastelement den Kühlkörper somit nicht seitlich, sondern wird durch den Kühlkörper und durch die Leuchtmittelplatine hindurch geführt und mit diesen verrastet, wobei in diesem Fall eine entsprechend groß ausgebildete Aussparung im Kühlkörper und in der Leuchtmittelplatine vorzusehen ist, so dass eine schwimmende Verbindung der Leuchtmittelplatine mit dem Kühlkörper ermöglicht wird.

Vorzugsweise weist der Leuchtmittelträger zumindest einen Führungs- und/oder Anlagewandungsabschnitt auf, an dem oder in dem die Leuchtmittelplatine mit dem Kühlkörper anordenbar ist. Ein derartiger Führungs- und/oder Anlagewandungsabschnitt kann beispielsweise durch einen die Leuchtmittelplatine und den Kühlkörper umlaufenden Wandungsabschnitt des Leuchtmittelträgers bereitgestellt werden.

Vorteilhafterweise ist zumindest eine der schwimmenden Verbindungen der Leuchtmittelplatine mit dem Kühlkörper durch zumindest eine Schraub- oder Nietverbindung bereitgestellt. Die schwimmende Verbindung kann dabei durch eine entsprechende lockere/lose Schraub- oder Nietverbindung bereitgestellt werden, beispielsweise indem die Leuchtmittelplatine mit dem Kühlkörper nicht fest verschraubt wird (d.h. die Schraube ist leicht gelöst, so dass eine Relativbewegung der Leuchtmittelplatine zum Kühlkörper ermöglicht wird).

Wie bereits oben ausgeführt, weist die Leuchtmittelplatine in Draufsicht gesehen, eine im Wesentlichen rechteckige Form auf.

Ferner betrifft die vorliegende Erfindung eine Lichtbandleuchte mit zumindest einem oben beschriebenen Leuchtmittelträger.

### 4. Beschreibung bevorzugter Ausführungsformen

Nachfolgend wird eine detaillierte Beschreibung der Figuren gegeben. In dieser zeigt:
- **Figur 1**: eine schematische Ansicht eines Leuchtmittelträgers (ohne Leuchtmittelplatine und ohne Kühlkörper), der in einer u-förmigen Lichtbandschiene einer Lichtbandleuchte angeordnet ist;
- **Figur 2**: eine schematische Ansicht eines Abschlussverbinders mit dem eine schwimmende Verbindung einer Leuchtmittelplatine mit einem Kühlkörper bereitgestellt werden kann;
- **Figur 3**: den Abschlussverbinder aus Figur 2 in einer weiteren Ansicht;
- **Figur 4**: eine schematische Ansicht eines Leuchtmittelträgers mit einer Leuchtmittelplatine, die mittels eines in den Figuren 2 und 3 gezeigten Abschlussverbinders an einem Stirnbereich mit einem Kühlkörper verbunden ist;
- **Figur 5**: einen Querschnitt durch den in Figur 4 gezeigten Leuchtmittelträger.

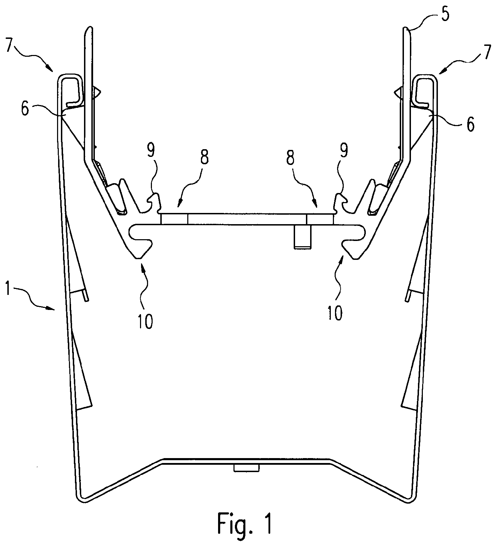

Figur 1 zeigt eine schematische Querschnittsansicht einer u-förmigen Lichtbandschiene 1, in der die verschiedenen Module einer Lichtbandleuchte angeordnet werden können, wobei in der in Figur 1 gezeigten u-förmigen Lichtbandschiene 1 nur ein erfindungsgemäßer Leuchtmittelträger 5 angeordnet ist (ohne Leuchtmittelplatine und ohne Kühlkörper).

Wie in Figur 1 gut zu erkennen ist, ist der Leuchtmittelträger 5 mittels mehrerer gegenüberliegend angeordneter Federelemente 6 mit der u-förmigen Lichtbandschiene 1 im Bereich zweier Vortragungen 7 der Lichtbandschiene 1 verrastet. Der Leuchtmittelträger 5 weist dabei einen an dem Querschnitt der Lichtbandschiene 1 angepassten u-förmigen Querschnitt auf, wobei dieser über die Lichtbandschiene 1 hinaussteht.

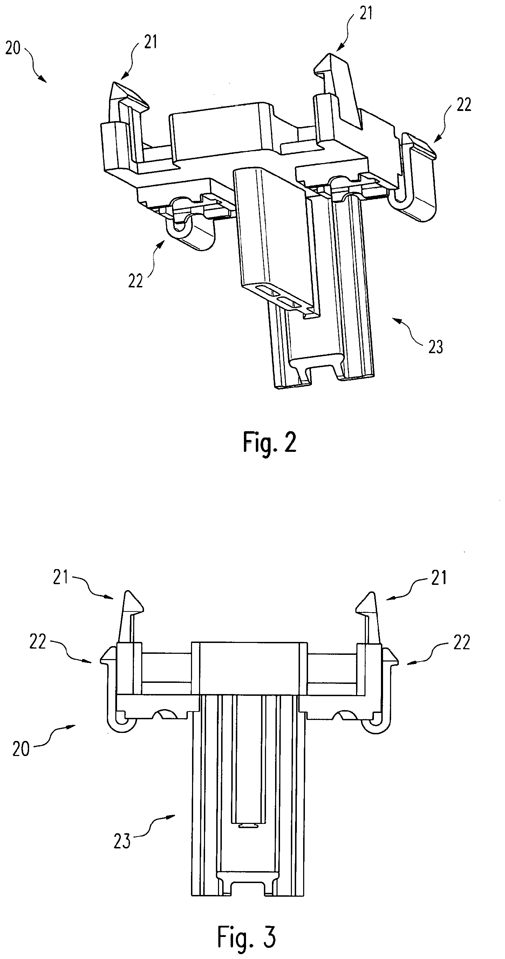

An der Basis des u-förmigen Querschnitts weist der Leuchtmittelträger 5 zwei Aussparungen 8 auf, durch die ein Rastelement eines Abschlussverbinders (vgl. Figur 2) oder einer Steckverbinderanordnung, die zur elektrischen Verbindung des Leuchtmittelträgers 5 mit einem darunter angeordneten Geräteträger (nicht gezeigt) ausgebildet ist.

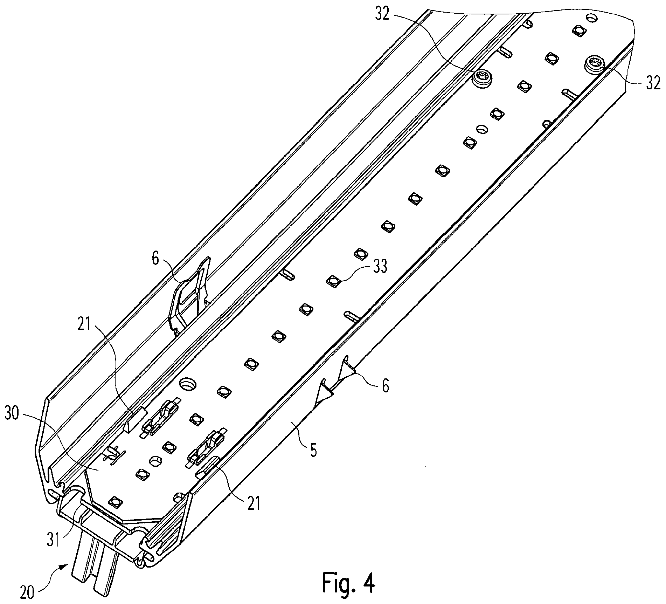

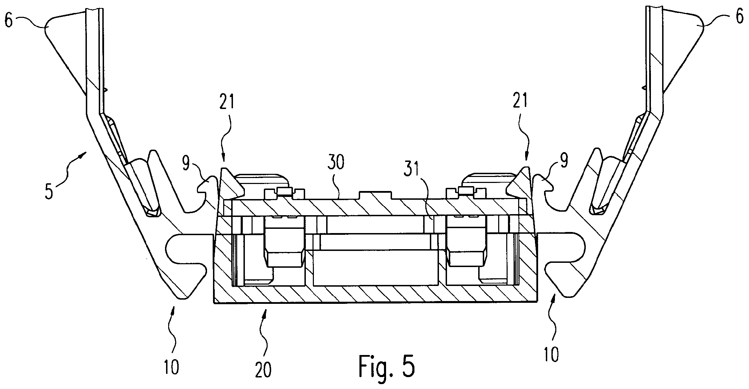

Benachbart zu den Aussparungen 8 weist der Leuchtmittelträger 5 in seiner Basis zwei gegenüberliegende Führungs- und/oder Anlagewandungsabschnitte 9 auf, wobei die Leuchtmittelplatine und der mit ihr verbundene Kühlkörper im Bereich zwischen den Führungs- und/oder Anlagewandungsabschnitten 9 angeordnet werden kann (vgl. Figuren 4 und 5).

Ferner umfasst der Leuchtmittelträger 5 in einem Bereich unter seiner Basis zwei gegenüberliegende Aufnahmen/Nuten 10, in die ein weiteres Rastelement des Abschlussverbinders einrastbar ist, um den Abschlussverbinder mit dem Leuchtmittelträger 5 zu verbinden.

Figur 2 zeigt eine schematische Ansicht eines Abschlussverbinders 20, der mit dem in Figur 1 gezeigten Leuchtmittelträger 5 verbindbar ist.

Der Abschlussverbinder 20 umfasst dabei zwei gegenüberliegende Rastelemente 21, die korrespondierend zu den Aussparungen 8 des Leuchtmittelträgers 5 am Abschlussverbinder 20 angeordnet sind.

Weiterhin umfasst der Abschlussverbinder 20 zwei weitere gegenüberliegende Rastelemente 22, die ausgebildet sind, um in die am Leuchtmittelträger 5 vorgesehenen Aufnahmen 10 einzurasten. Ferner umfasst der Abschlussverbinder 20 ein Positionier- und/oder Abstandselement 23, das in den Bereich zwischen den Leuchtmittelträger 5 und der Lichtbandschiene 1, vorzugsweise formschlüssig, eingeführt zu werden.

Figur 3 zeigt eine weitere schematische Ansicht des Abschlussverbinders 20, wobei gleiche Teile mit gleichen Bezugszeichen versehen sind.

Figur 4 zeigt eine schematische Ansicht eines Leuchtmittelträgers 5, in dem eine Leuchtmittelplatine 30 (mit darauf angeordneten Leuchtioden 33) thermisch mit einem Kühlkörper 31 verbunden ist, wobei die Leuchtmittelplatine 30 mit dem Kühlkörper 31 in einem zentralen Bereich mittels zweier (benachbarter) Schraubverbindungen 32 starr verbunden sind und in einem Stirnbereich mittels eines Abschlussverbinders 20 (d.h. durch ein seitliches Hintergreifen der Rastelemente 21 des Kühlkörpers 31 an einer Oberseite der Leuchtmittelplatine 30, so dass die Leuchtmittelplatine 30 auf den Kühlkörper 31 gehalten bzw. gedrückt wird).

Wie in Figur 4 gut zu erkennen ist, erlaubt die schwimmende Verbindung im stirnseitigen Bereich, dass sich die Leuchtmittelplatine 30 und der Kühlkörper 31 relativ zueinander bewegen, nämlich in Längsrichtung des Leuchtmittelträgers 5 dadurch, dass sich die Leuchtmittelplatine 30 bzw. der Kühlkörper 31 unter den Rastelementen 21 des Abschlussverbinders 20 hindurchschieben und in eine Richtung quer zu Längserstreckung des Leuchtmittelträgers 5 dadurch, dass die Rastelemente 21 durch die Leuchtmittelplatine 30 bzw. durch den Kühlkörper 31 auseinander gedrückt werden.

Trotz der Möglichkeit der Relativbewegung zueinander gewährleistet die Rastverbindung (bzw. auch die unten noch näher erläuterte Alternative Befestigung mittels einer Schraubverbindung), dass die Leuchtmittelplatine 30 und der Kühlkörper 31 in einer thermisch wirksamen Verbindung zueinander gehalten werden.

Figur 5 zeigt eine schematische Querschnittsansicht des in Figur 4 gezeigten Leuchtmittelträgers 5 in einem Bereich der Rastelemente 21. Gleiche Teile sind wiederum mit gleichen Bezugszeichen versehen.

Alternativ zu den in den Figuren gezeigten seitlichen Anordnung der Rastelemente 21 besteht die Möglichkeit, Rastelemente durch die Leuchtmittelplatine 30 und durch den Kühlkörper 31 zu führen, wobei in diesem Fall eine entsprechend große Aussparung in der Leuchtmittelplatine 30 und in dem Kühlkörper 31 vorzusehen ist, damit weiterhin eine schwimmende Anordnung, also eine Relativbewegung des Kühlkörpers 31 zur Leuchtmittelplatine 30, ermöglicht wird.

Ferner besteht die Möglichkeit eine schwimmende Verbindung in den Stirnbereichen (anstatt durch den gezeigten Abschlussverbinder 20) dadurch bereitzustellen, dass die Leuchtmittelplatine 30 an den Kühlkörper 31 geschraubt wird, wobei in diesem Fall eine lose Verschraubung vorgesehen wird, um wiederum eine Relativbewegung des Kühlkörpers 31 zur Leuchtmittelplatine 30 zu erlauben (die vorzugsweise unterstützt wird durch die Verwendung eines Langlochs, durch das Schraube geführt wird). Die Verschraubungen können auch an denselben Positionen, wie die in den Figuren gezeigten Rastelemente 21 vorgesehen sein, wobei in diesem Fall der Schraubenkopf den Kühlkörper 31 und die Leuchtmittelplatine 30 seitlich umgreift.

Die vorliegende Erfindung ist nicht auf die vorher beschriebenen bevorzugten Ausführungsbeispiele beschränkt, solange sie vom Gegenstand der folgenden Ansprüche umfasst ist. Insbesondere ist die vorliegende Erfindung nicht auf den Einsatz des gezeigten Abschlussverbinders 20 beschränkt. Ferner können in den jeweiligen Stirnbereichen auch unterschiedliche Verbindungen eingesetzt werden (beispielsweise kann an einer Seite eine schwimmende Verbindung mittels des Abschlussverbinders 20 bereitgestellt werden, und an der gegenüberliegenden Seite mittels einer losen Schraubverbindung).

## Patentansprüche

1. Leuchtmittelträger (5) für eine Lichtbandleuchte, umfassend:
- zumindest eine Leuchtmittelplatine (30) mit darauf anordenbaren Leuchtdioden (33);
- zumindest einen mit der Leuchtmittelplatine (30) thermisch verbundenen Kühlkörper (31);
- wobei die Leuchtmittelplatine (30) an einem zentralen Bereich starr mit dem Kühlkörper (31) verbunden ist, derart dass im zentralen Bereich im Wesentlichen keine Relativbewegung zwischen der Leuchtmittelplatine (30) und dem Kühlkörper (31) möglich ist;
- wobei die Leuchtmittelplatine (30) an zumindest zwei weiteren Bereichen schwimmend mit dem Kühlkörper (31) verbunden ist, so dass die Leuchtmittelplatine (30) außerhalb des zentralen Bereichs relativ zum Kühlkörper (31) beweglich am Kühlkörper (31) angeordnet ist.

2. Leuchtmittelträger (5) nach Anspruch 1, wobei die Leuchtmittelplatine (30) im zentralen Bereich zumindest durch eine Niet-, Schraub- (32) und/oder Clipverbindung starr mit dem Kühlkörper (31) verbunden ist.

3. Leuchtmittelträger (5) nach einem der Ansprüche 1 oder 2, wobei die zumindest zwei weiteren Bereiche, an denen die Leuchtmittelplatine (30) schwimmend mit dem Kühlkörper (31) verbunden ist, an zwei gegenüberliegenden Stirnbereichen der Leuchtmittelplatine (30) vorgesehen sind.

4. Leuchtmittelträger (5) nach einem der vorhergehenden Ansprüche, wobei zumindest eine der schwimmenden Verbindungen der Leuchtmittelplatine (30) mit dem Kühlkörper (31) durch zumindest eine Rastverbindung mittels eines Rastelements (21) oder durch zumindest eine Schraub- oder Nietverbindung bereitgestellt ist.

5. Leuchtmittelträger (5) nach Anspruch 4, wobei das zumindest eine Rastelement (21) an einem Abschlussverbinder (20) einer Lichtbandleuchte vorgesehen ist,
wobei der Abschlussverbinder (20) vorzugsweise zumindest ein weiteres Rastelement (22) umfasst, um den Abschlussverbinder (20) mit einer korrespondierend ausgebildeten Aufnahme (10) des Leuchtmittelträgers (5) zu verrasten, und/oder
wobei der Abschlussverbinder (20) vorzugsweise weiterhin ein Positionier- und/oder Abstandselement (23) umfasst, das im stirnseitigen Bereich zwischen dem Leuchtmittelträger (5) und einer Lichtbandschiene (1) einer Lichtbandleuchte anordenbar ist.

6. Leuchtmittelträger (5) nach einem der vorhergehenden Ansprüche, wobei zumindest eine der schwimmenden Verbindungen der Leuchtmittelplatine (30) mit dem Kühlkörper (31) durch zumindest eine Rastverbindung mittels eines Rastelements bereitgestellt wird, das an einer Steckverbinderanordnung vorgesehen ist, die eingerichtet ist, um den Leuchtmittelträger (5) mit einem Geräteträger einer Lichtbandleuchte elektrisch zu verbinden.

7. Leuchtmittelträger (5) nach einem der Ansprüche 4 bis 6, wobei das zumindest eine Rastelement (21) oder die Schraubverbindung den Kühlkörper (31) seitlich umgreift und die Leuchtmittelplatine (30) in Kontakt mit dem Kühlkörper hält.

8. Leuchtmittelträger (5) nach Anspruch 4 bis 7, wobei das Rastelement (21) des Abschlussverbinders (20) und/oder das Rastelement der Steckverbinderanordnung durch zumindest eine korrespondierend ausgebildete Aussparung (8) des Leuchtmittelträgers (5) mit der Leuchtmittelplatine (30) in Eingriff bringbar ist, derart dass das Rastelement (21) den Kühlkörper (31) seitlich umgreift und die Leuchtmittelplatine (30) in Kontakt mit dem Kühlkörper (31) hält.

9. Leuchtmittelträger (5) nach einem der Ansprüche 4 bis 8, wobei zumindest ein Rastelement (21) des Abschlussverbinders (20) und/oder der Steckverbinderanordnung durch zumindest eine korrespondierend ausgebildete Aussparung des Leuchtmittelträgers mit der Leuchtmittelplatine (30) in Eingriff bringbar ist, derart dass das Rastelement (21) durch eine Aussparung des Kühlkörpers (31) und der Leuchtmittelplatine (30) durch den Kühlkörper (31) und die Leuchtmittelplatine (30) hindurch ragt und die Leuchtmittelplatine (30) in Kontakt mit dem Kühlkörper (31) hält.

10. Leuchtmittelträger (5) nach einem der vorhergehenden Ansprüche, wobei zumindest eine der schwimmenden Verbindungen der Leuchtmittelplatine (30) mit dem Kühlkörper (31) durch zumindest eine Schraub- oder Nietverbindung derart bereitgestellt ist, dass die Leuchtmittelplatine (30) eine Aussparung aufweist durch die die Schraubverbindung geführt wird, so dass die Leuchtmittelplatine (30) mit dem Kühlkörper (31) verschraubt ist.

11. Leuchtmittelträger (5) nach einem der vorhergehenden Ansprüche, wobei zumindest eine der schwimmenden Verbindungen der Leuchtmittelplatine (30) mit dem Kühlkörper (31) durch zumindest eine Schraub- oder Nietverbindung derart bereitgestellt ist, dass der Kühlkörper (31) eine Aussparung aufweist, durch die die Schraubverbindung geführt wird, so dass die Leuchtmittelplatine (30) und der Kühlkörper (31) mit dem Leuchtmittelträger verschraubt sind.

12. Leuchtmittelträger (5) nach einem der Ansprüche 10 oder 11, wobei die Aussparung durch die Leuchtmittelplatine (30) und/oder durch den Kühlkörper (31) als Langloch bereitgestellt ist.

13. Leuchtmittelträger (5) nach einem der vorhergehenden Ansprüche, wobei der Leuchtmittelträger (5) zumindest einen Führungs- und/oder Anlagewandungsabschnitt (9) umfasst, an dem oder in dem die Leuchtmittelplatine (30) mit dem Kühlkörper (31) anordenbar ist.

14. Leuchtmittelträger (5) nach einem der vorhergehenden Ansprüche, wobei die Leuchtmittelplatine (30) in Draufsicht gesehen eine im Wesentlichen rechteckige Form aufweist.

15. Lichtbandleuchte, umfassend zumindest einen Leuchtmittelträger (5) nach einem der Ansprüche 1 bis 14.

## Claims

1. A lighting-means carrier (5) for a strip-lighting luminaire, comprising:
- at least one lighting-means circuit board (30) having light-emitting diodes (33) that can be arranged thereon;
- at least one heat sink (31) thermally connected to the lighting-means circuit board (30);
- wherein in a central region, the lighting-means circuit board (30) is rigidly connected to the heat sink (31), in such a manner that substantially no relative motion between the lighting means circuit board (30) and the heat sink (31) is possible;
- wherein in at least two further regions, the lighting-means circuit board (30) is connected to the heat sink (31) in a floating manner, so that the lighting-means circuit board (30) is arranged on the heat sink (31) in such a manner that the lighting-means circuit board can be moved in relation to the heat sink (31) outside of the central region.

2. A lighting-means carrier (5) according to Claim 1, wherein in the central region the lighting-means circuit board (30) is connected rigidly to the heat sink (31) at least by a rivet-, screw- (32) and/or clip connection.

3. A lighting-means carrier (5) according to any one of Claims 1 or 2, wherein the at least two further regions, on which the lighting-means circuit board (30) is connected in a floating manner with the heat sink (31), are provided on two opposite end regions of the lighting-means circuit board (30).

4. A lighting-means carrier (5) according to any one of the preceding claims, wherein at least one of the floating connections of the light-means circuit board (30) is provided with the heat sink (31) by at least one latching connection by means of a latching element (21) or by at least one screw- or rivet connection.

5. A lighting-means carrier (5) according to Claim 4, wherein the at least one latching element (21) is provided on a terminator connector (20) of a strip-lighting luminaire,
wherein the terminator connector (20) preferably comprises a further latching element (22), in order to latch the terminator connector (20) with the correspondingly designed receptacle (10) of the lighting-means carrier (5), and/or
wherein the terminator connector (20) preferably additionally comprises a positioning- and/or spacing element (23), which can be arranged in the end-face region between the lighting-means carrier (5) and a strip-lighting rail (1) of a strip-lighting luminaire.

6. A lighting-means carrier (5) according to any one of the preceding claims, wherein at least one of the floating connections of the lighting-means circuit board (30) is provided with the heat sink (31) by at least one latching connection by means of a latching element, which is provided on a plug connector arrangement, which is set up, in order to electrically connect the lighting-means carrier (5) with a device carrier of a strip-lighting luminaire.

7. A lighting-means carrier (5) according to any one of Claims 4 to 6, wherein the at least one latching element (21) or the screw connection laterally engages around the heat sink (31) and holds the lighting-means circuit board (30) in contact with the heat sink.

8. A lighting-means carrier (5) according to claim 4 to 7, wherein the latching element (21) of the terminator connector (20) and/or the latching element of the plug connector arrangement can be brought into engagement with the lighting means circuit board (30) by at least one correspondingly designed recess (8) of the lighting-means carrier (5), in such a manner that the latching element (21) laterally engages around the heat sink (31) and holds the lighting-means circuit board (30) in contact with the heat sink (31).

9. A lighting-means carrier (5) according to any one of Claims 4 to 8, wherein at least one latching element (21) of the terminator connector (20) and/or the plug connector arrangement can be brought into engagement with the lighting-means circuit board (30) by at least one correspondingly designed recess of the lighting-means carrier, in such a manner that the latching element (21) by means of a recess of the heat sink (31) and the lighting-means circuit board (30) protrudes through the heat sink (31) and the lighting-means circuit board (30) and holds the lighting-means circuit board (30) in contact with the heat sink (31).

10. A lighting-means carrier (5) according to any one of the preceding claims, wherein at least one of the floating connections of the lighting-means circuit board (30) is provided with the heat sink (31) by means of at least one screw- or rivet connection in such a manner that the lighting-means circuit board (30) has a recess through which the screw connection is guided, so that the lighting-means circuit board (30) is screwed together with the heat sink (31).

11. A lighting-means carrier (5) according to any one of the preceding claims, wherein at least one of the floating connections of the lighting-means circuit board (30) is provided with the heat sink (31) by at least one screw- or rivet connection in such a manner that the heat sink (31) has a recess, through which the screw connection is guided, so that the lighting-means circuit board (30) and the heat sink (31) are screwed together with the lighting-means carrier.

12. A lighting-means carrier (5) according to any one of Claims 10 or 11, wherein the recess through the lighting-means circuit board (30) and/or through the heat sink (31) is provided as an elongate hole.

13. A lighting-means carrier (5) according to any one of the preceding claims, wherein the lighting-means carrier (5) comprises at least one guide- and/or abutment wall section (9), on which or in which the lighting-means circuit board (30) can be arranged with the heat sink (31).

14. A lighting-means carrier (5) according to any one of the preceding claims, wherein the lighting-means circuit board (30) seen in top view has a substantially rectangular shape.

15. A strip-lighting luminaire, comprising at least one lighting-means carrier (5) according to any one of Claims 1 to 14.

## Revendications

1. Support de moyen d'éclairage (5) pour un luminaire pour bandeau lumineux, comprenant :
- au moins une platine de moyen d'éclairage (30) sur laquelle peuvent être disposées des diodes électroluminescentes (33) ;
- au moins un dissipateur thermique (31) raccordé thermiquement à la platine de moyen d'éclairage (30) ;
- la platine de moyen d'éclairage (30) étant raccordée rigidement au dissipateur thermique (31) dans une zone centrale de telle sorte que, dans la zone centrale, aucun mouvement relatif n'est essentiellement possible entre la platine de moyen d'éclairage (30) et le dissipateur thermique (31) ;
- la platine de moyen d'éclairage (30) étant, dans au moins deux autres zones, raccordée au dissipateur thermique (31) de façon flottante de telle sorte que la platine de moyen d'éclairage (30) est disposée sur le dissipateur thermique (31) à l'extérieur de la zone centrale de façon mobile par rapport au dissipateur thermique (31).

2. Support de moyen d'éclairage (5) selon la revendication 1, la platine de moyen d'éclairage (30) étant, dans la zone centrale, raccordée rigidement au dissipateur thermique (31) au moins par un raccordement riveté, vissé (32) et/ou clipsé.

3. Support de moyen d'éclairage (5) selon l'une des revendications 1 ou 2, les au moins deux autres zones sur lesquelles la platine de moyen d'éclairage (30) est raccordée de façon flottante au dissipateur thermique (31) étant prévues dans deux zones frontales opposées de la platine de moyen d'éclairage (30) .

4. Support de moyen d'éclairage (5) selon l'une des revendications précédentes, au moins un des raccordements flottants de la platine de moyen d'éclairage (30) au dissipateur thermique (31) étant réalisé par au moins un raccordement par encliquetage au moyen d'un élément d'encliquetage (21) ou par au moins un raccordement vissé ou riveté.

5. Support de moyen d'éclairage (5) selon la revendication 4, l'élément d'encliquetage (21) au moins au nombre de un étant prévu sur un raccord terminal (20) d'un luminaire pour bandeau lumineux,
le raccord terminal (20) comprenant de préférence au moins un autre élément d'encliquetage (22) pour encliqueter le raccord terminal (20) avec un logement (10) du support de moyen d'éclairage (5) de constitution correspondante, et/ou
le raccord terminal (20) comprenant de préférence également un élément de positionnement et/ou d'espacement (23) qui peut être disposé dans la zone côté frontal entre le support de moyen d'éclairage (5) et un rail de bandeau lumineux (1) d'un luminaire pour bandeau lumineux.

6. Support de moyen d'éclairage (5) selon l'une des revendications précédentes, au moins un des raccordements flottants de la platine de moyen d'éclairage (30) au dissipateur thermique (31) étant réalisé par au moins un raccordement par encliquetage au moyen d'un élément d'encliquetage qui est prévu sur un ensemble de connecteur enfichable qui est agencé pour connecter électriquement le support de moyen d'éclairage (5) à un support d'appareil d'un luminaire pour bandeau lumineux.

7. Support de moyen d'éclairage (5) selon l'une des revendications 4 à 6, l'élément d'encliquetage (21) au moins au nombre de un ou le raccordement vissé enserrant latéralement le dissipateur thermique (31) et maintenant la platine de moyen d'éclairage (30) en contact avec le dissipateur thermique.

8. Support de moyen d'éclairage (5) selon les revendications 4 à 7, l'élément d'encliquetage (21) du raccord terminal (20) et/ou l'élément d'encliquetage de l'ensemble de connecteur enfichable pouvant être mis en prise avec la platine de moyen d'éclairage (30) par au moins un évidement (8) du support de moyen d'éclairage (5) de constitution correspondante de telle sorte que l'élément d'encliquetage (21) enserre latéralement le dissipateur thermique (31) et maintient la platine de moyen d'éclairage (30) en contact avec le dissipateur thermique (31).

9. Support de moyen d'éclairage (5) selon l'une des revendications 4 à 8, au moins un élément d'encliquetage (21) du raccord terminal (20) et/ou de l'ensemble de connecteur enfichable pouvant être mis en prise avec la platine de moyen d'éclairage (30) par au moins un évidement du support de moyen d'éclairage de constitution correspondante de telle sorte que, à travers un évidement du dissipateur thermique (31) et de la platine de moyen d'éclairage (30), l'élément d'encliquetage (21) fait saillie à travers le dissipateur thermique (31) et la platine de moyen d'éclairage (30) et maintient la platine de moyen d'éclairage (30) en contact avec le dissipateur thermique (31) .

10. Support de moyen d'éclairage (5) selon l'une des revendications précédentes, au moins un des raccordements flottants de la platine de moyen d'éclairage (30) au dissipateur thermique (31) étant réalisé par au moins un raccordement vissé ou riveté de telle sorte que la platine de moyen d'éclairage (30) comporte un évidement à travers lequel le raccordement vissé est guidé de telle sorte que la platine de moyen d'éclairage (30) est assemblée par vissage au dissipateur thermique (31).

11. Support de moyen d'éclairage (5) selon l'une des revendications précédentes, au moins un des raccordements flottants de la platine de moyen d'éclairage (30) au dissipateur thermique (31) étant réalisé par au moins un raccordement vissé ou riveté de telle sorte que le dissipateur thermique (31) comporte un évidement à travers lequel le raccordement vissé est guidé de telle sorte que la platine de moyen d'éclairage (30) et le dissipateur thermique (31) sont assemblés par vissage au support de moyen d'éclairage.

12. Support de moyen d'éclairage (5) selon l'une des revendications 10 ou 11, l'évidement à travers la platine de moyen d'éclairage (30) et/ou le dissipateur thermique (31) étant réalisé sous forme de trou allongé.

13. Support de moyen d'éclairage (5) selon l'une des revendications précédentes, le support de moyen d'éclairage (5) comprenant au moins un tronçon de guidage et/ou de paroi d'appui (9) sur lequel ou dans lequel la platine de moyen d'éclairage (30) peut être disposée avec le dissipateur thermique (31).

14. Support de moyen d'éclairage (5) selon l'une des revendications précédentes, la platine de moyen d'éclairage (30) présentant en vue de dessus une forme essentiellement rectangulaire.

15. Luminaire pour bandeau lumineux, comprenant au moins un support de moyen d'éclairage (5) selon l'une des revendications 1 à 14.
